(19) Europäisches Patentamt
European Patent Office
Office européen des brevets

(11) **EP 3 639 549 B1**

(12) # EUROPÄISCHE PATENTSCHRIFT

(45) Veröffentlichungstag und Bekanntmachung des Hinweises auf die Patenterteilung:
**16.06.2021 Patentblatt 2021/24**

(21) Anmeldenummer: **18782304.2**

(22) Anmeldetag: **17.09.2018**

(51) Int Cl.:
*H04W 24/00* (2009.01)     *G01S 13/76* (2006.01)
*G01S 13/46* (2006.01)

(86) Internationale Anmeldenummer:
**PCT/EP2018/000436**

(87) Internationale Veröffentlichungsnummer:
**WO 2019/052687 (21.03.2019 Gazette 2019/12)**

(54) **VERFAHREN FÜR FUNKMESSANWENDUNGEN**

METHOD FOR RADIO MEASURING APPLICATIONS

PROCÉDÉ POUR DES APPLICATIONS DE MESURE RADIO

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.09.2017 DE 102017008647**
**15.09.2017 US 201762559116 P**

(43) Veröffentlichungstag der Anmeldung:
**22.04.2020 Patentblatt 2020/17**

(73) Patentinhaber: **Metirionic GmbH**
**01069 Dresden (DE)**

(72) Erfinder: **EGGERT, Dietmar**
**01219 Dresden (DE)**

(74) Vertreter: **Koch Müller**
**Patentanwaltsgesellschaft mbH**
**Maaßstraße 32/1**
**69123 Heidelberg (DE)**

(56) Entgegenhaltungen:
**EP-A1- 2 244 098       EP-A1- 3 067 712**
**WO-A1-2005/119379     WO-A2-02/01247**

EP 3 639 549 B1

**Beschreibung**

Die Erfindung betrifft ein Verfahren für Funkmessanwendungen mit wenigstens zwei Funkknoten zur Ermittlung einer Transferfunktion und/oder eines Zeitversatzes zwischen den Funkknoten.

Es gibt eine Vielzahl von Verfahren zur Abstandsermittlung auf Basis der Messung von Phasen und Phasen-Differenzen von Referenz-Signalen im Frequenzbereich. Das Grundprinzip ist seit mehr als 50 Jahren bekannt, z.B. aus der US 3 243 812. Das Verfahren wird seit Jahrzehnten in Verschiedenen Applikation angewandt. Neben einer Vielzahl von Publikation gibt es auch eine ganze Reihe von Patenten.

Aus der DE 10 2009 060 505 B4 ist ein Verfahren zur Kommunikation zwischen zwei Funkknoten bekannt, wobei die Funkknoten wechselseitig Signale senden und empfangen und die Trägerfrequenzen der Signale für jede Wiederholung geändert werden. Die von dem zweiten Funkknoten extrahierten Phasenwerte werden im Anschluss an den ersten Funkknoten rückübertragen und dann mit den empfangenen Signalen des ersten Funkknoten ausgewertet, um einen Abstand zwischen den beiden Funkknoten zu bestimmen.

Aus der DE 10 2009 060 593 A1 ist ein weiteres Verfahren zur Entfernungsmessung zwischen zwei Funkknoten bekannt, wobei die Funkknoten unmodulierte Trägersignale austauschen, jeder Funkknoten zwei Phasenwerte für zwei Frequenzen ermittelt und aus den insgesamt vier Phasenwerten die Entfernung zwischen den Funkknoten bestimmt wird.

Alternative Verfahren zur Entfernungsmessung zwischen zwei Funkknoten sind aus der DE 10 2009 592 B4, der WO 02/01247 A2 und der DE 10 2009 060 591 A1 bekannt.

Aus der WO 2005/119379 A1 ist ein Verfahren zur Korrektur von Jitter bekannt, wobei ein erster Funkknoten auf ein ausgesandtes Initialsignal ein Antwortsignal von einem zweiten Funkknoten erhält und das Antwortsignal sowohl den von dem zweiten Funkknoten ermittelten Empfangszeitpunkt des Initialsignals sowie den Sendezeitpunkt des Antwortsignals selbst enthält.

Vor diesem Hintergrund besteht die Aufgabe der Erfindung darin, ein Verfahren anzugeben, das den Stand der Technik weiterbildet.

Die Aufgabe wird durch ein Verfahren für Funkmessanwendungen mit den Merkmalen des Patentanspruchs 1 gelöst. Vorteilhafte Ausgestaltungen der Erfindung sind Gegenstand der Unteransprüche.

Gemäß dem Gegenstand der Erfindung wird ein Verfahren für Funkmessanwendungen vorgeschlagen, wobei wenigstens zwei Funkknoten bereitgestellt werden.

Mindestens ein erster Funkknoten arbeitet als Initiator und mindestens ein zweiter Funkknoten arbeitet als Transponder.

Jeder Funkknoten weist jeweils einen Zeitgeber und eine Datenschnittstelle auf, wobei zwischen den Zeitgebern der Funkknoten ein Zeitversatz besteht.

In einem ersten Schritt wird von dem Initiator mit einer ersten Trägerfrequenz ein Initialsignal gesendet und von dem Transponder während eines ersten Empfangszeitraums das Initialsignal empfangen.

In einem zweiten Schritt wird von dem Transponder mit einer zweiten Trägerfrequenz ein Antwortsignal gesendet und von dem Initiator während eines zweiten Empfangszeitraums das Antwortsignal empfangen.

Der erste Schritt und der zweite Schritt bilden eine Schrittfolge. Während eines Messzyklus wird mindestens eine Schrittfolge ausgeführt, wobei zuerst die ersten Schritte aller Schrittfolgen und danach die zweiten Schritte zumindest eines Teils der Schrittfolgen ausgeführt werden.

Die erste Trägerfrequenz des Initialsignals nimmt für jede Wiederholung der Schrittfolge einen vorbestimmten Wert innerhalb eines vorbestimmten Frequenzbereichs an.

Die Initialsignale und die Antwortsignale aller Schrittfolgen sind zumindest während des Messzyklus zueinander kohärent.

Das Verfahren umfasst einen ersten Modus und einen zweiten Modus.

In dem ersten Modus wird das Antwortsignal zumindest aus einem Teil des empfangenen Initialsignals gebildet und eine Transferfunktion und/oder der Zeitversatz anhand zumindest eines Teils der empfangenen Antwortsignale ermittelt.

In dem zweiten Modus wird das Antwortsignal unabhängig von dem empfangenen Initialsignal gebildet, mindestens ein empfangenes Initialsignal mittels der Datenschnittstelle übermittelt und mindestens eine Transferfunktion und/oder der Zeitversätze anhand zumindest eines Teils der empfangenen Antwortsignale und zumindest eines Teils der empfangenen und übermittelten Initialsignale ermittelt.

Es versteht sich, dass jeder Funkknoten eine Empfangseinheit, eine Sendeeinheit, einen Signalprozessor, eine Datenschnittstelle und wenigstens eine Antenne umfasst.

Umfasst ein Funkknoten mehrere Antennen, so wird das Initialsignal und/oder das Antwortsignal von einer der Antennen gesendet oder das Initialsignal und/oder das Antwortsignal wird von mehreren Antennen abgestrahlt. Beispielsweise strahlen die Antennen während eines Sendezeitraums sequentiell nacheinander ab. Der Sendezeitraum ist hierfür z.B. in mehrere Zeitfenster unterteilt, wobei jeweils eine der Antennen während eines Zeitfensters sendet. Es versteht sich, dass auch der Empfang der Signale entsprechend organisiert sein kann.

Alle mit dem erfindungsgemäßen Verfahren übermittelten Werte bzw. Signalvektoren können durch geeignete Verschlüsselungsmechanismen manipuliert werden, um die ablaufenden Vorgänge entsprechend zu schützen. So kann beispielsweise jeder Signalvektor mit einem zeitlich veränderlichen Zeitversatz belegt werden, der nur dem Initiator und dem Transponder a priori bekannt sind.

Die Datenschnittstelle ist gemäß alternativer Ausführungsformen drahtgebunden oder drahtlos ausgebildet und ermöglicht den Austausch von Daten, z.B. von ermittelten Signalvektoren, sowie die grobe Synchronisation der Funkknoten.

Als Initiator wird ein Funkknoten bezeichnet, der in einem ersten Schritt ein Signal aussendet.

Als Transponder wird ein Funkknoten bezeichnet, der das in einem ersten Schritt ausgesendete Signal empfängt und verarbeitet. Erst in einem zweiten Schritt sendet der Transponder ein Antwortsignal zurück.

Mittels des Verfahrens lassen sich ein Zeitversatz zwischen den einzelnen Zeitgebern und/oder eine Transferfunktion bestimmen. Voraussetzung ist, dass eine Kohärenz zwischen den Signalen des ersten Schritts und den Signalen des zweiten Schritts besteht.

Die Transferfunktion bildet die Übertragungseigenschaften zwischen zwei Funkknoten im Frequenzbereich ab, also die Übertragung eines Signals über ein Ausbreitungsmedium, und stellt im Bereich der drahtlosen Datenübertragung eine übliche Bezeichnung dar. Vielfach wird die Transferfunktion auch als Übertragungsfunktion bezeichnet.

Es versteht sich, dass sich mittels einer Fourier-Transformation die aufgenommen Werte aus dem Frequenzbereich in den Zeitbereich transformieren lassen. Im Zeitbereich ist für das Übertragungsverhalten eines Ausbreitungsmediums auch der Begriff Kanalimpulsantwort üblich.

Das Verfahren umfasst einen ersten und einen zweiten Modus, wobei jeder Modus für sich geschlossen ist. Maßgeblich für Modus 1 ist, dass innerhalb des Signalaustauschs zusätzliche Informationen innerhalb des Messsignals übermittelt werden, während Modus 2 ausschließlich die Datenschnittstelle für die Übertragung dieser Informationen nutzt. Ein System arbeitet jeweils innerhalb eines Zeitraums in einem der Modi. Ein Übergang zwischen den Modi ist möglich.

Mittels des Verfahrens ist es möglich, eine Übertragungsfunktion für das Ausbreitungsverhalten eines Ausbreitungsmediums von dem Initiator zu dem Transponder oder von dem Transponder und zu dem Initiator (auch als 1WR-Einwegtransferfunktionen bezeichnet) oder für einen Umlauf, also eine Übertragung von dem Initiator zu dem Transponder und von dem Transponder zu dem Initiator zurück (auch als 2WR-Umlauftransferfunktion bezeichnet) zu bestimmen.

Aus der ermittelten Transferfunktion im Frequenzbereich lässt sich wiederum der Abstand zwischen den beteiligten Funkknoten bestimmen.

Dabei kommt insbesondere dem Phasengang zwischen den Signalen eine besondere Bedeutung zu. Wird das Ausbreitungsverhalten innerhalb eines Mediums von dem direkten Pfad dominiert, dann lässt sich aus dem Phasengang über eine Ableitung die Gruppenlaufzeiten $t_g$ der elektromagnetischen Welle ermitteln.

$$t_g = \frac{d\varphi}{d\omega}$$

Über die Ausbreitungsgeschwindigkeit c der elektromagnetischen Welle entsteht eine direkte Beziehung zu dem Abstandes d zwischen den Funkknoten entsprechend d=c·$t_g$.

Kennzeichnend für alle Messverfahren ist das wechselseitige Senden eines Referenzsignals, also des Initialsignals bzw. des Antwortsignals, das vom anderen Knoten empfangen wird, wobei dabei die Lage des Empfangssignals in der komplexen Ebene bzgl. seiner internen Zeitreferenz bewertet wird.

Eine Schrittfolge aus dem ersten Schritt und dem zweiten Schritt stellt eine Art Kernoperation dar, die auch als Atomic Operation oder als Ping-Pong bezeichnet wird.

Die Phasenkohärenz muss im Minimum über eine Schrittfolge erhalten sein.

Der Übertragungskanal ist in vielen Fällen durch mehrere Wege gekennzeichnet, wobei neben der direkten Verbindung zwischen zwei Funkknoten auch weitere Pfade durch Reflexion an Gegenständen und/oder durch Brechung und/oder durch Beugung entstehen können.

Um mehrere Wege in den empfangenen Signalen aufzulösen wird die Schrittfolge, also das wechselseitige Senden und Empfangen von Referenzsignalen, in Frequenzschritten über eine Bandbreite (vorbestimmten Frequenzbereich) mehrfach wiederholt. Hierdurch lässt sich die Transferfunktion basierend auf einer Menge von Stützstellen im Frequenzbereich ermitteln.

Die Bandbreite des vorbestimmten Frequenzbereichs ist bestimmend für die Fähigkeit des Verfahrens, Signal-Pfade mit unterschiedlichen Längen aufzulösen. Da es sich um eine frequenz-diskrete Darstellung handelt, bestimmt die Frequenzschrittweite den Bereich über den sich ein Abstand eindeutig ermitteln lässt und begrenzt gleichzeitig die Größe der eindeutig bestimmbaren Zeitversätze.

Der Messzyklus umfasst mindestens eine Schrittfolge und in der Regel mehrere Schrittfolgen. Dabei kann ein Messzyklus eine größere Anzahl erster Schritte als zweiter Schritte umfassen. Die Zeitdauer des Messzyklus ist von der Anzahl, Art und Zeitdauer der einzelnen Schrittfolgen und der verwendeten Frequenzen abhängig.

Die Änderung der ersten Trägerfrequenz kann auf unterschiedliche Weisen erfolgen.

Beispielsweise wird ein Frequenz-Sweep durchgeführt, wobei die erste Trägerfrequenz bei jeder Wiederholung während des Messzyklus jeweils um einen konstanten Wert innerhalb des vorgegebenen Frequenzbereichs erhöht oder verringert wird. Ein Sweep ist mit geringem Implementierungsaufwand umsetzbar. In der Regel ist es einfacher die Phasenbeziehungen über eine Vielzahl kleinerer Frequenzschritte aufrechtzuerhalten. Auf Grund von gesetzlichen Bestimmungen ist diese Ausführung jedoch für viele Anwendungen in der zulässigen Sendeleistung beschränkt.

Eine unregelmäßigere Änderung der Frequenz wird auch als Frequenz-Hopping bezeichnet. Die unterschiedlichen Frequenzen bzw. Werte für die Trägerfrequenz für jede einzelne Wiederholung sind beispielsweise in einem Lookup-Table hinterlegt oder richten sich nach einer vorgegebenen mathematischen Funktion. Beispielsweise kann das Frequenz-Hopping auf Basis von pseudorauschartigen Folgen durchgeführt werden, wodurch eine hohe Robustheit gegen Störquellen erreicht wird. Gleichzeitig erlaubt diese Ausführung des Verfahrens die Nutzung größerer Sendeleistungen bei Einhaltung der verschiedensten gesetzlichen Bestimmungen und regulatorische Vorgaben. Somit ist es möglich die Nutzung des Verfahrens auf größere Reichweiten zu erweitern.

Die Erhaltung der Phasenkohärenz der Signale über einen abgegrenzten Zeitraum (alle ersten Schritte und zumindest einen Teil der zweiten Schritte) und zwischen Funkknoten ist eine wichtige Eigenschaft des Verfahrens und eine Voraussetzung für eine Rekonstruktion des Signalverlaufs.

Die Kohärenz-Forderung ist je nach Ausführung auch auf mehrere Messzyklen auszuweiten.

Neben dem Abstand ist auch eine Extraktion von weiteren Parametern, z.B. einem Einfallswinkel zwischen Funkknoten (zwei oder mehrere) für eine relative Positionsbestimmung, möglich. Dazu sind die Empfangssignale mehrerer Antennen auszuwerten bzw. die Sendesignale auf mehrere Antennen determiniert zu verteilen. Dies kann parallel/gleichzeitig durch Nutzung mehrerer Sende- und Empfangseinheiten erfolgen. Alternative kann auch die Antennenzuordnung zeitlich nacheinander auf verschiedenen Zeitfenstern innerhalb der Schrittfolge und durch Umschalten der Antennen zwischen den Zeitfenstern erfolgen. Beim Umschalten sind entsprechende Einschwingvorgänge zu beachten.

Da sich auch das Umgebungsverhalten über verschiedenen Ausbreitungswege in der Transferfunktion abbildet, erlaubt das Verfahren in einer Weiterbildung auch eine Charakterisierung des elektromagnetischen Verhaltens der Umgebung und lässt sich damit auf sogenannte passive Radaranwendungen, wie die Ermittlung von Raumzuständen oder von Positionen und Bewegungen von Objekten, erweitern.

Es sei angemerkt, dass sofern weitere Funkquellen vorhanden sind, sich die elektromagnetische Strahlung auch von den weiteren Quellen im Messergebnis wiederspiegelt und in die Analyse einbezogen wird. Hierdurch ergibt sich die Möglichkeit der Ableitung von komplexen Ortszuständen, die u.a. sich für die Authentifizierung von Objekten verwenden lässt.

Vorzugsweise entspricht der vorbestimmte Frequenzbereich beispielsweise dem zur Verfügung stehenden Frequenzbereich, richtet sich also nach den von den verwendeten Funkknoten zur Verfügung gestellten Bandbreiten. Alternativ wird der technisch mögliche Frequenzbereich aufgrund gesetzlicher Vorgaben und/oder aufgrund einer konkreten Anwendung eingeschränkt, so dass der vorbestimmte Frequenzbereich nur einen Teilbereich des zur Verfügung stehenden Frequenzbereichs umfasst. Es versteht sich, dass bei der Übertragung der Signale durch die Luft, die Trägerfrequenzen entsprechend zur Auskopplung in Luft geeignet sein müssen.

Jeder Funkknoten folgt einem festen zeitlichen Ablauf, der fest an den Zeitgeber und die entsprechende Zyklussteuerung gebunden und daher deterministisch ist. Damit haben alle Funktionsblöcke über die erforderlichen Zeiträume einen festen Zeit- und Phasenbezug und erfüllen die jeweiligen Forderungen nach Phasenkohärenz. Da das Zeitverhalten der Funkknoten unter den Knoten a-priori (mit Ausnahme von Initialphasenlage, Zeit- und Frequenzoffset) bekannt ist, entsteht eine Kohärenzbeziehung zwischen den Funkknoten.

Für den Ablauf des Verfahrens des Verfahrens ist es jedoch wichtig, das die entsprechenden Sende- und Empfangszeiträume (ggfs. auch Sende- und Empfangszeitfenster) sich gegenüberstehen und entsprechende Einschwingvorgänge abgeschlossen sind, d.h. ein stationärer Zustand hergestellt wird.

Die tolerierbare Schwankung des Zeitversatzes, die durch eine GrobSynchronisation abgesichert wird, orientiert sich an der Größe des Messbereichs und sollte z.B. bei einem Messbereich von 300m geringer als $1\mu s$ sein um erhöhte Aufwände in Zeit- und Frequenzoffsetkorrektur zu vermeiden. Die erreichbare Messgenauigkeit im 2.4GHz Bereich liegt bei unter einem 1m.

Bzgl. dieser Eigenschaft unterscheidet sich dieses Verfahren maßgeblich von etablierten UWB TDOA (Time Difference of Arrival) Verfahren. Da hier die Messgenauigkeit durch die Synchronisation bestimmt wird, muss die Synchronisationsgüte bei vergleichbarer Genauigkeit besser als 3ns sein.

Wie angemerkt, verfügt jeder Funkknoten über eine eigene Zeitreferenz. Vorzugsweise ist die Zeitreferenz als Quarzoszillator (XTAL/XOSC) ausgebildet. Es versteht sich, dass der grobe Zeitabgleich nicht die Ermittlung des tatsächlichen Zeitoffsets bei einer Kernoperation ersetzt, sondern eine Voraussetzung ist.

Ein Vorteil ist, dass sich die Flexibilität des Verfahrens und die Zuverlässigkeit erhöht. Ein anderer Vorteil ist, dass sich das Verfahren schneller und kostengünstiger durchführen lässt.

Die Ermittlung des Zeitoffsets bzw. des Zeitversatzes zweier an der Kommunikation beteiligter Funkknoten ist für eine Weiterverarbeitung der Messergebnisse von Bedeutung.

In einer Weiterbildung lässt sich der Zeitversatz auch für die Synchronisation von Einheiten eines Systems verwenden und besitzt daher eine wichtige Bedeutung.

Als Datenschnittstelle wird jede weitere Art eines Datenaustauschs bezeichnet, also beispielsweise ein Kommunikationsprotokoll für einen drahtlosen Austausch, z.B. Bluetooth, Zigbee oder IEEE 802.11, welches einen Austausch von Datenframes zur groben Synchronisation auch ohne weiteren Vorrichtungs-technischen Aufwand ermöglicht. Alternativ kann die Datenschnittstelle als eine Datenleitung bzw. Anschluss für eine Datenleitung ausgebildet sein.

Wird gemäß dem ersten Modus das Antwortsignal zumindest aus einem Teil des empfangenen Initialsignals gebildet, so werden entsprechend Informationen über das empfangene Initialsignal direkt an den Initiator zurück übermittelt. Das empfangene Antwortsignal enthält somit Informationen über Hin- und Rückweg zwischen den Funkknoten. Dies ermöglicht es, allein anhand der empfangenen Antwortsignale die 2WR-Transferfunktion zu ermitteln.

Wird gemäß dem zweiten Modus das Antwortsignal unabhängig von dem Initialsignal gebildet, so wird gemäß einer ersten alternativen Ausführungsform mindestens ein von dem Transponder ermittelter Empfangssignalvektor mittels der Datenschnittstellen an den Initiator übermittelt. So kann die weitere Auswertung von dem Initiator oder einer mit dem Initiator kommunizierenden Recheneinheit vorgenommen werden. Anhand der empfangenen Antwortsignale und der empfangene und übermittelten Initialsignale kann die 2WR-Transferfunktion ermittelt werden.

Wird anhand von mindestens einem Initialsignal und mindestens einem Antwortsignal der Zeitversatz bestimmt, so ist es möglich, die 1WR-Transferfunktion zu bestimmen. Die ist sowohl in dem ersten Modus als auch in dem zweiten Modus möglich.

Ein Vorteil des erfindungsgemäßen Verfahrens ist somit, dass eine weitere Datenübermittlung aller oder zumindest vieler Messergebnisse des Transponders entfällt. Hierdurch kann sowohl der technische als auch der zeitliche Aufwand reduziert werden.

In einer ersten Ausführungsform werden die ersten Schritte der Schrittfolgen während des Messzyklus gemäß einer erste Reihenfolge ausgeführt und die zweiten Schritte der Schrittfolgen werden entsprechend der ersten Reihenfolge oder in einer zu der ersten Reihenfolge umgekehrten Reihenfolge ausgeführt. Wird die Frequenz beispielsweise mit jeder weiteren Schrittfolge erhöht, so ergibt sich ein über die ersten Schritt ansteigender Frequenzverlauf. Werden die zweiten Schritte in derselben Reihenfolge ausgeführt, springt der Frequenzverlauf auf den Ausgangswert zurück und steigt über die zweiten Schritte wieder an. Werden die zweiten Schritte dagegen in umgekehrter Reihenfolge ausgeführt, so nimmt der Frequenzverlauf von dem Wert des letzten ersten Schritts ausgehend über die zweiten Schritte ab.

Gemäß einer weiteren Ausführungsform entspricht die zweite Trägerfrequenz innerhalb jeder Schrittfolge der ersten Trägerfrequenz. Alternativ unterscheidet sich die zweite Trägerfrequenz innerhalb einer Schrittfolge von der ersten Trägerfrequenz.

Es versteht sich, dass der zeitliche Verlauf der Trägerfrequenzen bzw. die Frequenzänderungen den beteiligten Funkknoten vorab bekannt sind. Die zweite Trägerfrequenz wird beispielsweise immer der ersten Trägerfrequenz entsprechend geändert. Die Änderung der zweiten Trägerfrequenz erfolgt alternativ unabhängig von der Änderung der ersten Trägerfrequenz oder gar nicht. Die Änderung, d.h. der bei einer Wiederholung vorgenommene Frequenzschritt, ist bei jeder Wiederholung gleich oder ändert sich bei jeder Wiederholung, beispielsweise gemäß einer vorgegebenen allen Funkknoten bekannten Liste oder mathematischen Funktion, die auch das zeitliche Verhalten einschließt und damit die erforderliche Phasenkohärenz erhält.

In einer weiteren Ausführungsform werden die zweiten Schritte aller Schrittfolgen während des Messzyklus ausgeführt. Ein Messzyklus umfasst somit die gleiche Anzahl von ersten und zweiten Schritten.

In einer Ausführungsform wird aus dem empfangenen Initialsignal ein erster komplexer Signalvektor (Empfangssignalvektor) ermittelt, wobei das Antwortsignal aus dem ersten komplexen Signalvektor oder alternativ aus dem reziproken ersten komplexen Signalvektor gebildet wird.

Für die erste Alternative entspricht das von dem Initiator empfangene Antwortsignal einer frequenzweisen Multiplikation des komplexen Signalvektors mit der Kanaltransferfunktion des Ausbreitungsmediums. Im Ergebnis entsteht das im Frequenzbereich diskret abgetastete Quadrat der Kanaltransferfunktion. Im Zeitbereich entspricht dieses Ergebnis der zeitdiskret abgetasteten Faltung der Kanalimpulsantwort mit sich selbst.

Für die zweite Alternative liefert das von dem Initiator empfangene Antwortsignal einem Verzögerungsoperator $e^{j\omega \cdot 2 \cdot T_{off}}$, der die Ermittlung des Zeitversatz zwischen den beiden Funkknoten erlaubt. Mit Hilfe dieser Größe kann die 1WR-Kanaltransferfunktion ermittelt werden. Weiterhin kann diese Größe auch als Stellgröße innerhalb von Präzisionssynchronisationen und auch zum Test einer zeitlichen Synchronisation von Funktionsblöcken verwendet werden.

In einer anderen Ausführungsform wird ein erster komplexer Signalvektor ermittelt und das Antwortsignal aus dem konjugiert komplexen ersten komplexen Signalvektor gebildet wird.

Das empfangene Antwortsignal besteht aus dem Betragsquadrat des ersten komplexen Signalvektors sowie einem Verzögerungsoperation, der durch den Zeitversatz zwischen den Knoten gekennzeichnet ist.

Gemäß weiterer alternativer Ausführungsform wird aus dem empfangenen Initialsignal eine erste Phase ermittelt, wobei das Antwortsignal entweder aus der ersten Phase oder aus der invertierten ersten Phase gebildet wird. Diese Alternativen sind besonders einfach und schnell.

In anderen alternativen Ausführungsformen arbeitet immer mindestens ein Funkknoten als Initiator und immer mindestens ein Funkknoten als Transponder, wobei jeder Funkknoten über mehrere Schrittfolgen mindestens einmal als Initiator und mindestens einmal als Transponder arbeitet oder jeder Funkknoten über mehrere Schrittfolgen nur als Initiator oder nur als Transponder arbeitet.

Ist festgelegt, welche Funktion ein Funkknoten erfüllen muss, ist es möglich, die Funktionalitäten der einzelnen Funkknoten an die Funktion anzupassen und die Funkknoten dadurch gegebenenfalls zu vereinfachen und kostengünstiger auszuführen.

In einer anderen Ausführungsform wird anhand der ermittelten Transferfunktion und/oder des Zeitversatzes ein Abstand zwischen dem mindestens einen Initiator und dem mindestens einen Transponder bestimmt. Aus den gewonnenen Ergebnissen lässt sich eine Positionsbestimmung eines der Funkknoten durchführen.

Gemäß einer Weiterbildung wird für mindestens eine ermittelte Kanaltransferfunktion eine Mehrwege-Analyse durchgeführt. Die Mehrwegeanalyse fokussiert sich auf die Auswertung der indirekten Ausbreitungswege. Auf diese Weise werden die verschiedensten Formen von passiven Radaranwendungen möglich. Diese reichen je nach Komplexität von einfacher Bewegungsdetektion (z.B. zur Raumüberwachung) bis zur Bilderstellung auf Basis der Funkwellen.

Gemäß einer anderen Weiterbildung wird vor der Ermittlung der Transferfunktion und/oder des Zeitversatzes auf die empfangenen Antwortsignale und/oder die empfangenen Initialsignale ein Filter angewandt. Als Filter kann beispielsweise ein cos^2-Fenster zur Unterdrückung von Nebenmaxima eingesetzt werden. Eine höhere Messdynamik bzw. Rauschunterdrückung kann beispielsweise durch Average-Bildung der Messwerte innerhalb einer Schrittfolge erfolgen.

In einer weiteren Weiterbildung werden bei jeder Wiederholung zusätzlich zu der Trägerfrequenz des Initialsignals eine Amplitude und/oder eine Phase des Initialsignals verändert.

In einer weiteren Ausführungsform sendet der Initiator das Initialsignal während eines ersten Sendezeitraums und der Transponder sendet das Antwortsignal während eines zweiten Sendezeitraums, wobei der erste Sendezeitraum und der zweite Sendezeitraum jeweils mehrere, aufeinanderfolgende Zeitfenster umfassen, jeweils nur während der Zeitfenster gesendet wird und jeweils zwei aufeinanderfolgende Zeitfenster zeitlich unmittelbar aufeinander folgen oder zeitlich einen Abstand zueinander aufweisen.

Es versteht sich, dass auch die Empfangszeiträume mehrere Zeitfenster umfassen können, wobei die Zeitfenster der Sendezeiträume und die Zeitfenster der Empfangszeiträume einander (bis auf den Zeitversatz) entsprechen können, aber nicht müssen.

Diese Vorgehensweise erlaubt insbesondere die Anpassung an verschiedenen Applikationsanpassungen, wie getrennte Übertragung der Referenzphase, Signalisierung zwischen Initiator und Transponder (Verstärkungs- und Sendeleistungsanpassungen, Verschlüsselung), Rauschunterdrückung durch Mittelwertbildung, Zuordnung zu verschiedenen Antennen zur Erzeugung von Raumdiversität zur Ermittlung von Einfallswinkeln im speziellen und zur Verbesserung der Messgenauigkeit im Allgemeinen (Beam Steering, MIMO, Smart Antennas), oder auch zur Detektion von Kanalbelegungen im Sinne von LBT (Listen-before-Talk), CS (Carrier Sense) und DAA (Detect and Avoid) Anforderungen für die Zulassung von Funksystemen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. Abstände sowie laterale und vertikale Erstreckung sind nicht maßstäblich und weisen, sofern nicht anders angegeben, auch keine ableitbaren geometrischen Relationen zueinander auf. Darin zeigen,

Figur 1    eine schematische Messanordnung zur Durchführung eines erfindungsgemäßen Verfahrens für Funkmessanwendungen gemäß einer ersten alternativen Ausführungsform,

Figur 2    ein Ablaufschema der ersten alternativen Ausführungsform des Verfahrens für Funkmessanwendungen,

Figur 3    ein Schema des zeitlichen Verlaufs des Verfahrens für Funkmessanwendungen gemäß der ersten alternativen Ausführungsform,

Figur 4    eine schematische Messanordnung zur Durchführung des erfindungsgemäßen Verfahrens für Funkmessanwendungen gemäß einer zweiten alternativen Ausführungsform,

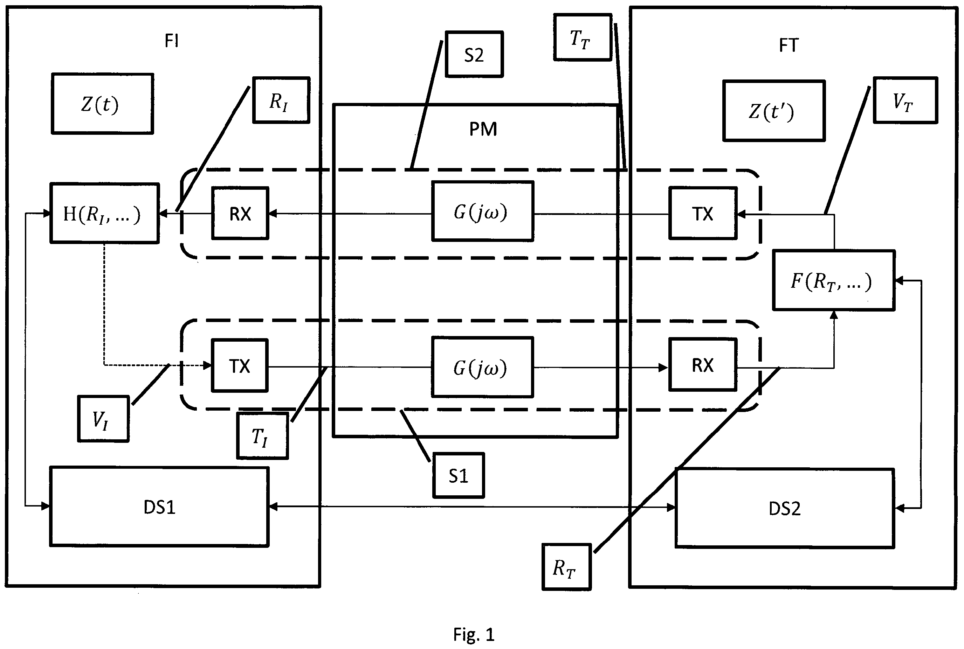

Die Abbildung der Figur 1 zeigt schematische eine Anordnung von zwei Funkknoten zur Durchführung einer ersten alternativen Ausführungsform eines erfindungsgemäßen Verfahrens für Funkmessanwendungen, wobei die Anordnung dazu ausgelegt ist, einen ersten Modus des erfindungsgemäßen Verfahrens auszuführen.

Ein als Initiator bezeichneter erster Funkknoten FI und ein als Transponder bezeichneter zweiter Funkknoten FT werden bereitgestellt. Initiator FI und Transponder FT weisen jeweils eine Empfangseinheit RX, eine Sendeeinheit TX, eine Datenschnittstelle DS1 bzw. DS2 und einen eigenen Zeitgeber Z(t) bzw. Z(t') auf.

Die Datenschnittstellen DS1 und DS2 sind als Kommunikationsprotokoll für einen drahtlosen Datenaustausch ausgebildet. Zwischen dem ersten Zeitgeber Z(t) des ersten Funkknoten FI und dem zweiten Zeitgeber Z(t') des zweiten Funkknoten besteht ein Zeitversatz $T_{offs}$. Die Zeitgeber sind jeweils als ein Quarzoszillator ausgebildet.

Der Initiator FI ist dazu ausgelegt während eines ersten Schritt S1 mittels der Sendeeinheit TX über ein Ausbreitungsmedium PM, z.B. Luft, ein Initialsignal $T_I$ zu senden. Der Transponder FT ist dazu ausgelegt während des ersten Schritts S1 das von dem Initiator FI ausgesandte Initialsignal $T_I$ nach einer Übertragung über das Ausbreitungsmedium PM als Empfangssignal $R_T$ zu empfangen.

Außerdem ist der Transponder FT dazu ausgelegt, aus dem Empfangssignal $R_T$ mit Hilfe einer Funktion $F(R_T,..)$ einen Signalvektor $V_T$ zu ermitteln und mittels der Datenschnittstelle DS2 auszutauschen.

Um den ersten Modus des erfindungsgemäßen Verfahrens ausführen zu können, ist der Transponder FT zusätzlich dazu ausgelegt, den Signalvektor $V_T$ an die Sendeeinheit TX zu übermitteln und mittels der Sendeeinheit TX weiter zu verarbeiten.

Während eines zweiten Schritts S2 sendet der Transponder FT mittels der Sendeeinheit TX ein Antwortsignal $T_T$. Der Initiator FI empfängt während des zweiten Schritts S2 mittels der Empfangseinheit RX das von dem Transponder ausgesandte Antwortsignal $T_T$ nach Übertragung über das Ausbreitungsmedium PM als Empfangssignal $R_I$.

Außerdem ist der Initiator FI dazu ausgelegt, aus dem Empfangssignal $R_I$ mit Hilfe der Funktion $H(R_I,..)$ Signalvektor $V_I$ zu ermitteln und mit der Datenschnittstelle DS1 auszutauschen.

Der Einfluss der Übertagung über das Ausbreitungsmedium PM auf die ausgesandten Signale wird als Transferfunktion G bezeichnet.

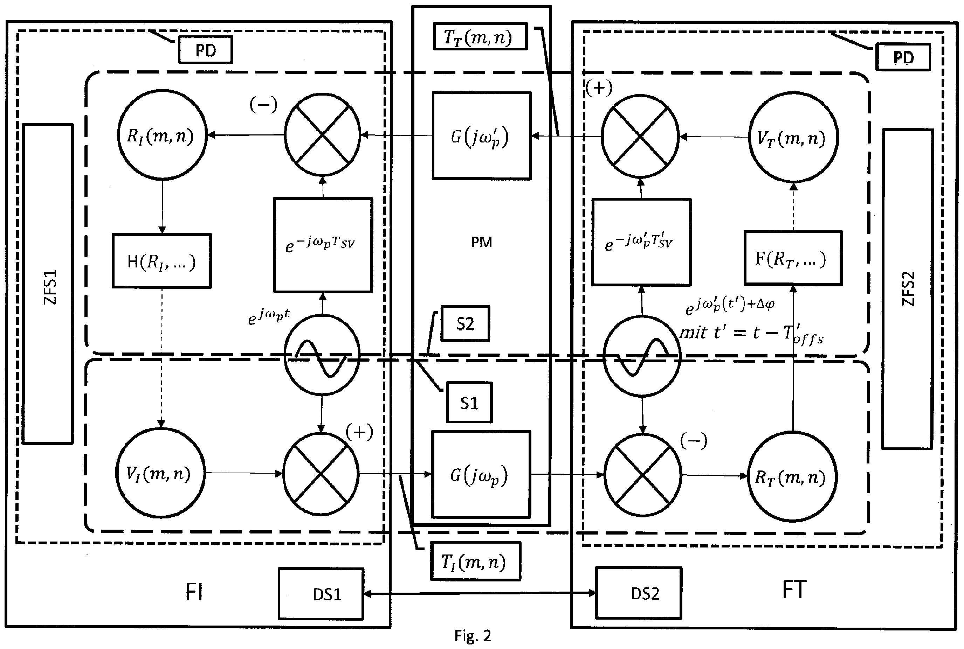

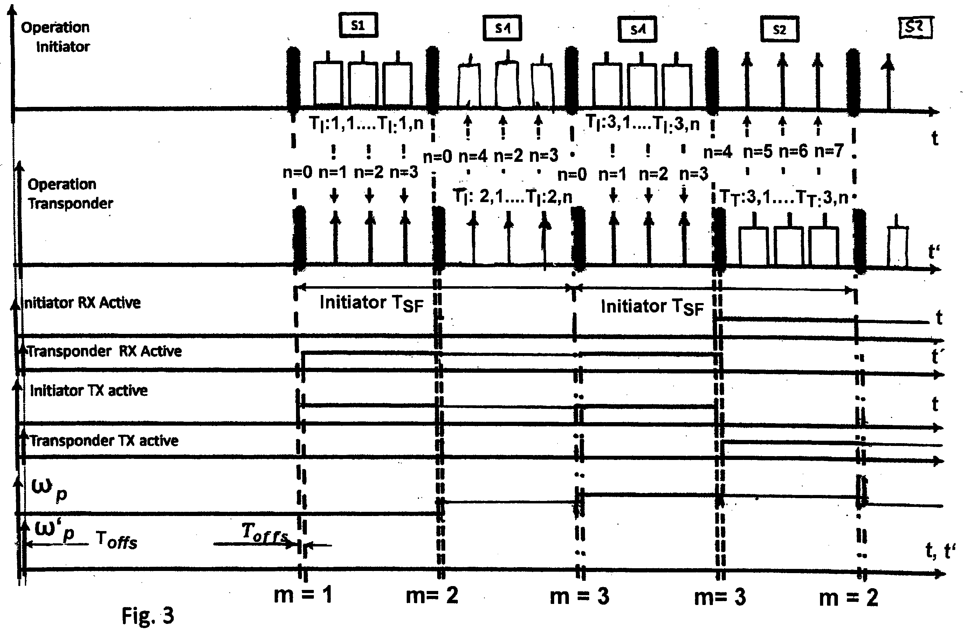

Ein Verfahrensablauf gemäß der ersten alternativen Ausführungsform des Verfahrens für Funkmessanwendungen wird im Folgenden anhand der Figuren 2 und 3 weiter erläutert.

Wie Figur 2 zeigt, besitzen beide Funkknoten FI und FT jeweils einen Generator, eine Aufwärtsmischer, der einen komplexen Signalvektor VT bzw. VI aus der Basisband-Lage in die HF-Lage konvertiert, einen Abwärtsmischer, der ein Hochfrequenzsignal in einen Signalvektor in der Basisbandlage konvertiert und eine den Zeitgeber Z(t) bzw. Z(t') Zeit- und Frequenzsteuerung ZFS1 bzw. ZFS2, die alle Systemzustandswechsel in einem festen Zeitregime steuert.

Die Zeit- und Frequenzsteuerung ZFS1 bzw. ZFS2 arbeitet auf Basis einer Zeiteinheit $T_{MU}$ und stellt sicher das alle relevanten Zustandswechsel (Sampling der Signalvektoren, RX/TX-TX/RX Übergänge, Frequenzwechsel fest mit der durch den jeweiligen Zeitgeber vorgegebenen Zeitbasis verbunden sind und auf diesen bezogen werden können.

Die Zeit- und Frequenzsteuerung ZFS1 bzw. ZFS2 ist auch dafür verantwortlich, dass die Kohärenz zwischen den Signalen über die geforderte Länge erhalten bleibt, d.h. Einschwingvorgänge berücksichtigt und sich alle Funktionseinheiten auch in den Übergangsbereichen im linearen Regelbereichen befinden (u.a. Frequenzgenerator, PLL). Die Funkknoten FI und FT werden durch die Zeit- und Frequenzsteuerung ZFS1 bzw. ZFS2 während der Schrittfolge aus Schritt S1 und S2 gesteuert.

Die Schrittfolge schließt auch die Übergangsbereiche (Schrittverzögerung) ein, die als Verzögerungs-glieder der Größe $T_{sv}$ dargestellt sind. Die Zeit- und Frequenzsteuerung ZFS1 bzw. ZFS2 übernimmt auch die Steuerung der Frequenz $\omega_p$ über einen verfügbaren Frequenzbereich.

Dadurch erzeugt die Zeit- und Frequenzsteuerung ZFS1 bzw. ZFS2 jeweils eine phasenkohärente Domain PD, in der die Hochfrequenzsynthese, die Erzeugung der entsprechenden Sendevektoren und die Extraktion der Empfangsvektoren zueinander phasenseitig in einer festen Beziehung stehen.

Weiterhin besitzt jeder Funkknoten jeweils eine Logikeinheit, die mittels einer Funktion F bzw. H auf Basis von Eingabeparametern (u.a. die empfangen Signalvektoren $R_I(m,n)$ und $R_T(m,n)$ und/oder über die Datenschnittstelle DS1 bzw. DS2 bereitgestellte Parameter) die Signalvektoren $V_T$ bzw. $V_I$ zur Erzeugung des entsprechenden Sendesignals $T_I(m,n)$ bzw. $T_T(m,n)$ bereitstellt.

Innerhalb der Abbildungen kennzeichnet n den Index innerhalb einer Schrittfolge, die insgesamt eine Dauer von $T_{SF}=n_{max}.T_{MU}$ besitzt. Der Index besitzt einen Wertebereich n=0,1,...(n$_{max}$-1), wobei sich $n_{max}$ aus der konkreten Auslegung des Messzyklus bestimmt und im dargestellten Beispiel $n_{max}$=8 gewählt wurde. Im Zusammenhang mit der Messeinheitszeit $T_{MU}$ bildet n die Basis für ein zeitdiskretes System auf der Basis t=n·$T_{MU}$+m·$T_{SF}$. m bezeichnet hier den Index der Schrittfolgen innerhalb eines Messzyklus mit m=1,2...(m$_{max}$). $m_{max}$ wird durch die konkrete Ausführung bestimmt und ist u.a. von der Anzahl der Frequenzen abhängig, für die die Übertragungsfunktion ermittelt werden soll. Eine Serie von Schrittfolgen wird als Messzyklus bezeichnet. Ein Messzyklus hat eine Länge von mindestens $T_z=m_{max}·T_{SF}$. Zur Unterscheidung zwischen Initiator Funkknoten FI und Transponder-Funkknoten FT sind die entsprechenden Größen des Transponders durch Anstriche (z.B. Frequenzen und Zeiten des f'$_p$ , $\omega'_p$ , t',...) gekennzeichnet.

Wie in Figur 2 und 3 veranschaulicht ist, erzeugen der Frequenzgenerator im Initiator FI und im Transponder FT jeweils zunächst ein Signal der Frequenz f$_p$, f$_p$' bzw. $\omega_p$ =2π·f$_p$ , $\omega'_p$ =2-f'$_p$ mit (p=1), wobei das Signal des Frequenzgenerators des Transponders um den Zeitoffset $T_{offs}$ verzögert ist und einen statischen Phasenoffset $\Delta\varphi$ besitzt. Im Sinne der weiteren Betrachtungen werden diese Frequenzen als gleich groß betrachtet. Es wird vorausgesetzt, dass entsprechende Frequenzoffsetkorrekturen (falls notwendig) bereits durchgeführt wurden bzw. die notwendigen Parameter extrahiert wurden um die Empfangsvektoren entsprechend zu korrigieren. Somit wird für die weiteren Aussagen f$_p$=f$_p$' angenommen, wobei das Verfahren auch Frequenzunterschiede f$_p$=f$_p$'+$\Delta$f' einschließt, wenn $\Delta$f bekannt, z.B. durch die Empfangsarchitektur vorgegeben, ist.

Das Verfahren umfasst mehrere Schrittfolgen aus einem ersten Schritt S1 und einem zweiten Schritt S2, wobei bei jeder Wiederholung der Schrittfolge, die Trägerfrequenzen $\omega_p$ und $\omega'_p$ innerhalb eines vorbe-

stimmten Frequenzbereichs nach den entsprechenden Anforderungen ausgewählt werden. Im dargestellten Ausführungsbeispiel entspricht die zweite Trägerfrequenz $\omega'_\rho$ der ersten Trägerfrequenz $\omega_p$.

Die mehreren Wiederholungen der Schrittfolge bilden einen Messzyklus. Erfindungsgemäße werden in jedem Messzyklus zuerst alle ersten Schritte S1 nacheinander ausgeführt, danach werden zweiten Schritte S2 der Schrittfolgen des Messzyklus ausgeführt.

In einem ersten Schritt S1 m=1, n=0,1,2,3 p=1 einer ersten Schrittfolge wird von dem Initiator FI mittels eines Mischers und des Frequenzgenerators ein Signal $T_I(m,n)$ mit einer ersten Trägerfrequenz $\omega_p$ mit einem Signalvektor $V_I(m,n)$ erzeugt und als Initialsignal $T_I(m,n)$ in das Ausbreitungsmedium PM ausgekoppelt. Zur Veranschaulichung sei der Signalvektor $T_I(m,n)$=1, d.h. der Initiator-Funkknoten sendet ein ReferenzSignal mit einer Trägerfrequenz $\omega_p$ als Initialsignal $T_I$.

Es versteht sich, dass das Vorbeschriebene nicht ausschließt, dass die Signalvektoren $V_I$ bzw. $V_T$ vor dem Auskoppeln in einem weiteren Mischer durch Multiplikation mit einem Hilfsträger, häufig als Local Oscillator bezeichnet, auf eine Zwischenfrequenz IF gebracht wird, bevor das Signal abschließend durch Umsetzung auf eigentlich Zielfrequenz $\omega_p$ umgesetzt wird.

Der Transponder FT bestimmt während eines ersten Empfangszeitraums im Schritt S1 mit m=0, n=0,1,2,3 ein Empfangssignal $R_T(m,n)$ durch Mischung des empfangenen HF-Signals mit dem Signal des Frequenzgenerators der Frequenz $f'_p$, das um Toffs gegenüber dem Generatorsignal des Initiators zeitlich verschoben ist.

Die Lage des Empfangssignals $R_T(m,n)$ in der komplexen Ebene wird durch den internen Zeitreferenz bzw. des zweiten Zeitgebers Z(t') mit t'=n·$T'_{MU}$ +m·$T'_{SF}$ des Transponders FT bestimmt und wird gegenüber dem Initiator maßgeblich durch die Übertragungsfunktion des Funkkanals auf der Frequenz $f_p$ und den Zeit-und Phasenoffset $T_{offs}$ bzw. $\Delta\varphi$ bestimmt zwischen den Zeitgebern bestimmt. Im Sinne des Verfahrens ist $T_{Mu}$=T'MU, $T_{SF}$=$T'_{SF}$, $T_z$=$T'_z$, usw. Anhand des Empfangssignals $R_T(m,n)$ wird ein Signalvektor $V_T(m,n+4)$=$F(R_T(m,n),...)$ gebildet und als Signalvektor $V_T$ an die Sendeeinheit TX des Transponders FT übermittelt.

Auch der Transponder bildet ein zeitdiskretes System mit t'=n·$T'_{MU}$ +m·$T'_{ASF}$.

In einem weiteren ersten Schritt S1 m=2, n=0,1,2,3 p=2 einer zweiten Schrittfolge wird von dem Initiator FI mittels eines Mischers und des Frequenzgenerators ein Signal $T_I(m,n)$ mit einer ersten Trägerfrequenz $\omega_p$ (p=2) mit einem Signalvektor $V_I(m,n)$ erzeugt und als Initialsignal $T_I(m,n)$ in das Ausbreitungsmedium PM ausgekoppelt und von dem Transponder während eines Empfangszeitraums in dem weiteren Schritt S1 mit m=2, n=0,1,2,3 p=2 ein Empfangssignal $R_T(m,n)$ durch Mischung des empfangenen HF-Signals mit dem Signal des Frequenzgenerators der Frequenz $f'_p$, das um Toffs gegenüber dem Generatorsignal des Initiators zeitlich verschoben ist, ermittelt.

Entsprechend wird in dem dargestellten Ausführungsbeispiel ein weiterer erster Schritt S1 mit m=3, n=0,1,2,3 und p=3 einer dritten Schrittfolge durchgeführt.

Danach werden die zweiten Schritte der drei Schrittfolgen in umgekehrter Reihenfolge ausgeführt.

In einem zweiten Schritt S2 m=3,n=4,5,6,7 und p=3 der dritten Schrittfolge wird von dem Transponder FT aus dem ermittelten Basisbandvektor $V_T(m,n)$ mittels eines Mischers und dem Frequenzgenerator ein Sende Signal $T_T(m,n)$ mit der Frequenz $f'_p$ erzeugt und als Antwortsignal $T_T$ in das Ausbreitungsmedium PM ausgekoppelt.

Das Antwortsignal $T_T$ m=3,n=4,5,6,7 wird dabei aus dem Empfangssignal $R_T(m,n)$ m=3,n=0,1,2,3 mit Hilfe der Funktion $F(R_T(m,n),...)$ und somit zumindest aus einem Teil des Empfangssignals $R_T$ gebildet.

Der Initiator FI bestimmt während eines Empfangszeitraums während des zweiten Schritts m=3,n=4,5,6,7 der dritten Schrittfolge ein Empfangssignal $R_I(m,n),...)$ mit m=3,n=4,5,6,7, wobei die Lage des Empfangssignals $R_I$ bezüglich der internen Zeitreferenz des Initiators FI bzw. des ersten Zeitgebers Z(t) mit der Zeit t=n·$T_{MU}$ +m·$T_{SF}$ bewertet wird. Dazu wird das empfangen HF Signal der Frequenz $f'_p$ mit einem Mischer und dem Signal des Frequenzgenerators der Frequenz $f_p$ in die Basisbandlage konvertiert.

Die entsprechenden zeitdiskreten Werte ergeben sich für den Initiator aus t=n·$T_{MU}$+m·$T_{SF}$ und den Transponder aus t'=n·$T'_{MU}$ +m·$T'_{SF}$.

Die zweiten Schritte S2 mit m=2, n=4,5,6,7 und p=2 der weiten Schrittfolge sowie der zweite Schritt S2 mit m=1, n=4,5,6,7 und p=1 der ersten Schrittfolge werden anschließend entsprechend durchgeführt.

Durch das Übermitteln von Informationen über das empfangene Initialsignal $T_I$ mittels des Antwortsignals $T_T$ ist es möglich, direkt anhand der empfangenen Antwortsignale $T_T$ eine Transferfunktion für den Umlauf (Schrittfolge aus Schritt S1 und Schritt S2) und/oder einen Zeitversatz zu ermitteln.

Um eine Kohärenz aller Initialsignale $T_I$ und Antwortsignale $T_T$ während eines Messzyklus zu gewährleisten, verfügen der Initiator FI sowie der Transponder FT jeweils über eine kohärente Zeit- und Frequenzkontrolle, wobei eine grobe Zeitsynchronisation, beispielsweise durch den Austausch von Datenframes über die Datenschnittstellen DS1 und DS2, erfolgt.

In der Figur 3 ist insbesondere der zeitliche Ablauf des Verfahrens skizziert. Über den Zeitachsen t bzw. t'=t+$T_{offs}$ sind der Verlauf der Frequenzen $\omega_p$ bzw. w'$_p$, eine Aktivität der Sendeeinheiten TX des Transponders FT und des Initiators FI, eine Aktivität der Empfangseinheiten RX des Transponders FT sowie des Initiators FI über drei Schrittfolgen m=1 bis m=3 dargestellt.

Darüber sind die Aktivitäten des Transponders FT und des Initiators FI als senkrechte verlaufende Balken dargestellt, wobei fette Balken jeweils das Umschalten von Empfangsmodus auf Sendemodus bzw. von Sendemodus auf Empfangsmodus, dünne Balken mit Kästen jeweils das Senden eines Signals innerhalb eines Sendezeitfensters und Pfeile das Empfangen eines Signals kennzeichnen.

Zwischen jeder Sendeaktivität und darauffolgenden Empfangsaktivität bzw. vice versa liegt immer eine Schrittverzögerung. Hierdurch werden Einflüsse bzw. Störungen durch einen Einschwingvorgang der Funkknoten vermieden. Die Schrittverzögerung ist entsprechend größer als eine Einschwingzeit der jeweiligen Knoten. Gleichzeitig ist zu vermerken, dass die vorgestellten Beziehungen einen eingeschwungenen stationären Zustand voraussetzen. Diese Bedingung ist nur für Bereiche der Schrittverzögerung erfüllt, die durch Übergangsbereiche abgegrenzt sind, in denen die entsprechenden Einschwingvorgänge stattfinden. In diesen sind die entsprechenden Signalvektoren nur eingeschränkt im Sinne des Verfahrens verwendbar. Für den dargestellten Fall betrifft dies die Vektoren $R_{I,T}(m,n)$ mit n=0,4.

Für die Umsetzung des Verfahrens im bisher dargestellten Sinne wird mindestens ein gültiger Empfangsvektor pro Funkknoten pro Schritt jeder Schrittfolge benötigt.

Die in der Figur 3 dargestellte Ausführungsform weist Sende- und Empfangszeiträume mit mehreren separaten Sende- bzw. Empfangszeitfenstern auf. Geht man von einer symmetrischen Verteilung zwischen dem Initiator FI und dem Transponder FT aus, so stehen die entsprechenden zeitkontinuierliche Sende-Signale $T_I$ und $T_T$ mit ihren Werten zu den Zeitpunkten t=n·$T_{MU}$ +m·$T_{SF}$ und t'n·$T'MU$ + m·$T'_{SF}$ auf der anderen Seite die entsprechende Anzahl an Empfangszeitfenster gegenüber und erlauben damit die Ermittlung der zugehörigen Empfangsvektoren $R_T$ und $R_I$.

Die somit zur Verfügung stehenden Zeitfenster bieten sich für verschiedene Zwecke an. Eine Auswahl sei hier zusammengestellt:

- Übertragung der Referenzphase des Transponders
- Signalisierung zwischen Initiator und Transponder (Verstärkungs- und Sendeleistungsanpassungen,..., Verschlüsselung)
- Rauschunterdrückung durch Mittelwertbildung von mehreren Empfangsvektoren die auf Basis eines Sendevektors der Gegenseite erzeugt wurden
- Zuordnung zu verschiedenen Antennen zur Erzeugung von Raumdiversität zur Ermittlung von Einfallswinkeln im speziellen und zur Verbesserung der Messgenauigkeit im Allgemeinen (Beam Steering, MIMO, Smart Antenna),
- Zur Detektion von Kanalbelegungen im Sinne von LBT (Listen-before-Talk), CS (Carrier Sense) und DAA (Detect and Avoid) Anforderungen für die Zulassung von Funksystemen.

Bei der Dimensionierung sind sowohl die jeweiligen Einschwingvorgänge als auch die Grenzen der durch die Grobsynchronisation erreichbaren maximalen Zeitoffsetschwankungen zu beachten und entsprechende die Guard-Intervalle Schrittverzögerung bzw. Einschwingzeit auszulegen.

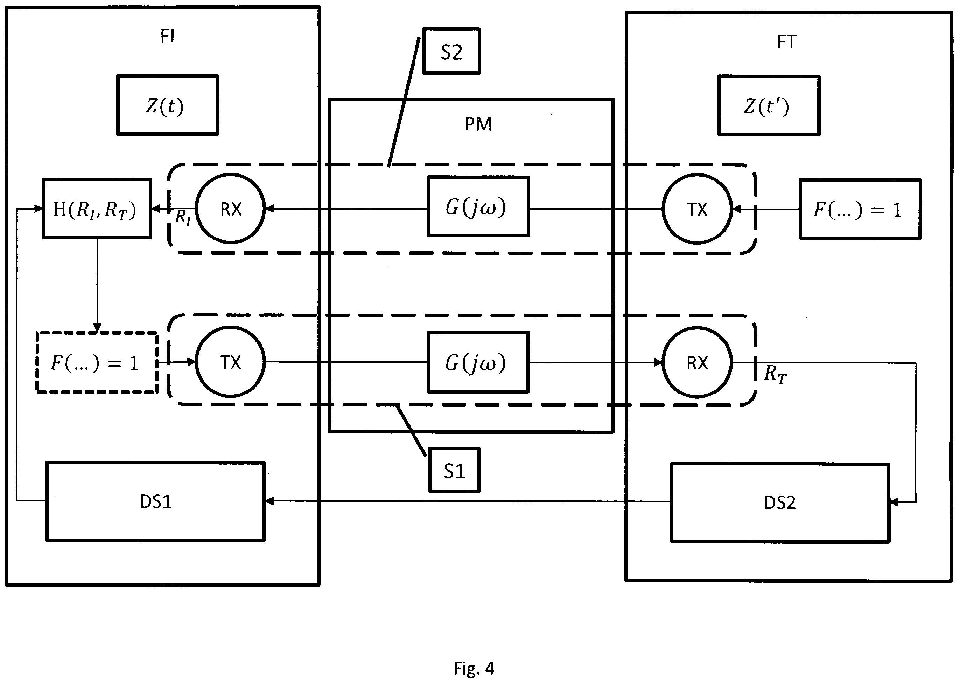

In der Figur 4 ist das erfindungsgemäße Verfahren gemäß einer ersten Ausführungsform des Modus 2 dargestellt. Im Folgenden werden die Unterschiede zu den vorangegangenen Figuren erläutert.

Figur 4 zeigt schematisch eine Anordnung des Initiators FI und des Transponders FT im Modus 2.

Jeder erste Schritt S1 wird zunächst in gleicher Form wie bei Modus 1 ausgeführt. Im Rahmen jedes zweiten Schritts S2 ist der Transponder FT dazu ausgelegt, mittels der Sendeeinheit TX das Antwortsignal $T_T$ zu erzeugen, wobei der Basisbandvektor $V_T$ zu $V_T(m,n)=1$ für die Erzeugung des Antwortsignals $T_T$ gewählt wird. Das bedeutet, dass der Transponder ein Signal $T_T$ sendet, dass nur von seiner eigenen Zeitreferenz abhängig ist und damit unabhängig vom Initiator Sendesignal $T_I$ bzw. dem daraus ermittelten Empfangssignalvektor $R_T$ unabhängig ist.

Der Transponder FT ist zusätzlich dazu ausgelegt, die in den ersten Schritten S1 ermittelten Empfangssignale $R_T$ zumindest teilweise mittels der Datenschnittstelle DS2 an den Initiator zu übermitteln.

Der Initiator FI ist zusätzlich dazu ausgelegt, die Empfangssignale $R_T$ mittels der Datenschnittstelle DS1 zu erhalten und anhand zumindest eines Teils der erhaltenen Empfangssignale $R_T$ und der ermittelten Messvektoren $R_I$ den Zeitversatz $T_{offs}$ zu bestimmen.

Anhand des Zeitversatzes $T_{offs}$ und zumindest eines Teils der von dem Initiator FI empfangenen Empfangssignale $R_I$ kann dann eine Transferfunktion für den Funkkanal zwischen dem Transponder FT und dem Initiator FI ermittelt werden. Es ist somit möglich direkt die Transferfunktion für einen einzigen Weg zwischen Initiator und Transponder und nicht für einen zwei Wege umfassenden Umlauf zu bestimmen.

**Patentansprüche**

1. Verfahren für Funkmessanwendungen, wobei

   - wenigstens zwei Funkknoten bereitgestellt werden,
   - mindestens ein erster Funkknoten als Initiator und mindestens ein zweiter Funkknoten als Transponder arbeitet,
   - in einem ersten Schritt von dem Initiator mit einer ersten Trägerfrequenz ein Initialsignal gesendet wird und von dem Transponder während eines ersten Empfangszeitraums das Initialsignal empfangen wird,
   - in einem zweiten Schritt von dem Transponder mit einer zweiten Trägerfrequenz ein Antwortsignal gesendet wird und von dem Initiator während eines zweiten Empfangszeitraums das Antwortsignal empfangen wird und

- der erste Schritt und der zweite Schritt eine Schrittfolge bilden,

- während eines Messzyklus mindestens eine Schrittfolge ausgeführt wird, wobei

- zuerst die ersten Schritte aller Schrittfolgen und danach die zweiten Schritte zumindest eines Teils der Schrittfolgen jeweils nacheinander ausgeführt werden,

- die erste Trägerfrequenz des Initialsignals für jede Wiederholung der Schrittfolge einen vorbestimmten Wert innerhalb eines vorbestimmten Frequenzbereichs annimmt und

- die Initialsignale und die Antwortsignale aller Schrittfolgen zumindest während des Messzyklus zueinander kohärent sind,

**dadurch gekennzeichnet, dass**

- jeder Funkknoten jeweils einen eigenen Zeitgeber und eine Datenschnittstelle aufweist,

- zwischen den Zeitgebern der Funkknoten jeweils ein Zeitversatz besteht und

- das Verfahren entweder in einem ersten Modus oder in einem zweiten Modus arbeitet, wobei

- in dem ersten Modus das Antwortsignal zumindest aus einem Teil des empfangenen Initialsignals gebildet und eine Transferfunktion und/oder der Zeitversatz anhand zumindest eines Teils der empfangenen Antwortsignale ermittelt wird, wobei

- in dem ersten Modus entweder aus dem Initialsignal ein erster komplexer Signalvektor ermittelt wird und das Antwortsignal aus dem ersten komplexen Signalvektor oder dem reziproken ersten komplexen Signalvektor oder dem konjugiert komplexen ersten komplexen Signalvektor gebildet wird oder

- aus dem empfangenen Initialsignal eine erste Phase ermittelt wird und das Antwortsignal aus der ersten Phase oder aus der invertierten ersten Phase gebildet wird und

- in dem zweiten Modus das Antwortsignal unabhängig von dem empfangenen Initialsignal gebildet wird, mindestens zu einem empfangenen Initialsignal ein Empfangssignalvektor ermittelt und mittels der Datenschnittstelle übermittelt wird und mindestens eine Transferfunktion und/oder der Zeitversätze anhand zumindest eines Teils der empfangenen Antwortsignale und zumindest eines Teils des übermittelten Empfangsvektors ermittelt wird.

2. Verfahren nach Anspruch 1, **dadurch gekennzeichnet, dass** die ersten Schritte der Schrittfolgen während des Messzyklus gemäß einer ersten Reihenfolge ausgeführt werden und die zweiten Schritte der Schrittfolgen entsprechend der ersten Reihenfolge oder in einer zu der ersten Reihenfolge umgekehrten Reihenfolge ausgeführt werden.

3. Verfahren nach Anspruch 1 oder 2, **dadurch gekennzeichnet, dass** innerhalb jeder Schrittfolge die zweite Trägerfrequenz der ersten Trägerfrequenz entspricht oder sich von der ersten Trägerfrequenz unterscheidet.

4. Verfahren nach einem der vorangegangenen Ansprüche, **dadurch gekennzeichnet, dass** während eines Messzyklus die zweiten Schritte aller Schrittfolgen ausgeführt werden.

5. Verfahren nach einem der vorangegangenen Ansprüche, **dadurch gekennzeichnet, dass** immer mindestens ein Funkknoten als Initiator und immer mindestens ein Funkknoten als Transponder arbeitet, wobei jeder Funkknoten über mehrere Schrittfolgen mindestens einmal als Initiator und mindestens einmal als Transponder arbeitet oder jeder Funkknoten über mehrere Schrittfolgen nur als Initiator oder nur als Transponder arbeitet.

6. Verfahren nach einem der vorangegangenen Ansprüche, **dadurch gekennzeichnet, dass** anhand der ermittelten Transferfunktion und/oder des Zeitversatzes ein Abstand zwischen dem mindestens einen Initiator und dem mindestens einen Transponder bestimmt wird.

7. Verfahren nach einem der vorangegangenen Ansprüche, **dadurch gekennzeichnet, dass** für mindestens eine ermittelte Transferfunktion eine Mehrwege-Analyse durchgeführt wird.

8. Verfahren nach einem der vorangegangenen Ansprüche, **dadurch gekennzeichnet, dass** auf die empfangenen Antwortsignale und/oder die empfangenen Initialsignale ein Filter angewandt wird.

9. Verfahren nach einem der vorangegangenen Ansprüche, **dadurch gekennzeichnet, dass** bei jeder Wiederholung der Schrittfolge zusätzlich zu der Trägerfrequenz des Initialsignals eine Amplitude und/oder eine Phase des Initialsignals verändert wird.

10. Verfahren nach einem der vorangegangenen Ansprüche, **dadurch gekennzeichnet, dass** der Initiator das Initialsignal während eines ersten Sendezeitraums sendet und der Transponder das Antwortsignal während eines zweiten Sendezeitraums sendet, wobei der erste Sendezeitraum und der zweite Sendezeitraum jeweils mehrere, aufeinanderfolgende Zeitfenster umfassen, jeweils nur während der Zeitfenster gesendet wird und jeweils zwei aufeinanderfolgende Zeitfenster zeitlich unmittelbar aufeinander folgen oder zeitlich einen Abstand zueinander aufweisen.

**Claims**

1.  Method for radio measuring applications, wherein

    - at least two radio nodes are provided,
    - at least one first radio node operates as an initiator and at least one second radio node operates as a transponder,
    - in a first step an initial signal is transmitted by the initiator at a first carrier frequency and the initial signal is received by the transponder during a first receiving time period,
    - in a second step a response signal is transmitted by the transponder at a second carrier frequency and the response signal is received by the initiator during a second receiving time period, and
    - the first step and the second step form a step sequence,
    - at least one step sequence is executed during a measuring cycle, wherein
    - initially the first steps of all step sequences and thereafter the second steps of at least a part of the step sequences are respectively executed in succession,
    - the first carrier frequency of the initial signal for each repetition of the step sequence adopts a predetermined value within a predetermined frequency range and
    - the initial signals and the response signals of all step sequences are coherent with respect to one another at least during the measuring cycle,

    **characterised in that**

    - each radio node respectively comprises an individual time transmitter and a data interface,
    - a respective offset in time is present between the time transmitters of the radio nodes and
    - the method operates either in a first mode or in a second mode, wherein
    - in the first mode the response signal is formed at least from a part of the received initial signal and a transfer function and/or the offset in time is determined on the basis of at least a part of the received response signals, wherein
    - in the first mode either a first complex signal vector is determined from the initial signal and the response signal is formed from the first complex signal vector or the reciprocal first complex signal vector or the conjugated complex first complex signal vector, or
    - a first phase is determined from the received initial signal and the response signal is formed from the first phase or from the inverted first phase and
    - in the second mode the response signal is formed independently of the received initial signal, a received signal vector is determined at least with respect to a received initial signal and is communicated by means of the data interface and at least one transfer function and/or the time offsets is or are determined on the basis of at least a part of the received response signals and at least a part of the communicated reception vector.

2.  Method according to claim 1, **characterised in that** the first steps of the step sequences are performed during the measuring cycle in accordance with a first sequence and the second steps of the step sequences are performed in correspondence with the first sequence or in a sequence reversed with respect to the first sequence.

3.  Method according to claim 1 or 2, **characterised in that** within each step sequence the second carrier frequency corresponds with the first carrier frequency or differs from the first carrier frequency.

4.  Method according to any one of the preceding claims, **characterised in that** during a measuring cycle the second steps of all step sequences are performed.

5.  Method according to any one of the preceding claims, **characterised in that** always at least one radio node operates as the initiator and always at least one radio node operates as the transponder, wherein each radio node operates over several step sequences at least once as the initiator and at least once as the transponder or each radio node operates over several step sequences only as the initiator or only as the transponder.

6.  Method according to any one of the preceding claims, **characterised in that** a spacing between the at least one initiator and the at least one transponder is determined on the basis of the determined transfer function and/or the time offset.

7.  Method according to any one of the preceding claims, **characterised in that** a multiway analysis is carried out for at least one determined transfer function.

8.  Method according to any one of the preceding claims, **characterised in that** a filter is used on the received response signals and/or the received initial signals.

**9.** Method according to any one of the preceding claims, **characterised in that** for reach repetition of the step sequence an amplitude and/or a phase of the initial signal is or are changed additionally to the carrier frequency of the initial signal.

**10.** Method according any one of the preceding claims, **characterised in that** the initiator transmits the initial signal during a first transmission time period and the transponder transmits the response signal during a second transmission time period, wherein the first transmission time period and the second transmission time period each comprise a plurality of successive time windows, in each instance there is transmission only during the time window and in each instance two successive time windows directly follow one another in time or have a mutual spacing in time.

## Revendications

**1.** Procédé pour des applications de mesure radio, dans lequel

- au moins deux nœuds radio sont prévus,
- au moins un premier nœud radio fonctionne en tant qu'initiateur et au moins un second nœud radio fonctionne en tant que transpondeur,
- dans une première étape, un signal initial qui présente une première fréquence porteuse est émis par l'initiateur et le signal initial est reçu par le transpondeur pendant une première période de réception,
- dans une seconde étape, un signal de réponse qui présente une seconde fréquence porteuse est émis par le transpondeur et le signal de réponse est reçu par l'initiateur pendant une seconde période de réception, et
- la première étape et la seconde étape constituent une suite d'étapes,
- au moins une suite d'étapes est réalisée pendant un cycle de mesure, dans lequel
- en premier lieu, les premières étapes de la totalité des suites d'étapes et ensuite les secondes étapes d'au moins une partie des suites d'étapes sont exécutées respectivement les unes à la suite des autres,
- la première fréquence porteuse du signal initial pour chaque répétition de la suite d'étapes adopte une valeur prédéfinie à l'intérieur d'une plage de fréquences prédéfinie, et
- les signaux initiaux et les signaux de réponse de la totalité des suites d'étapes sont cohérents les uns par rapport aux autres au moins pendant le cycle de mesure,

**caractérisé en ce que** :

- chaque nœud radio présente respectivement un temporisateur propre et une interface de données,
- un décalage temporel est respectivement présent entre les temporisateurs des nœuds radio, et
- le procédé fonctionne soit dans un premier mode soit dans un second mode, dans lequel
- dans le premier mode, le signal de réponse est constitué au moins d'une partie du signal initial reçu et une fonction de transfert et/ou le décalage temporel est (sont) déterminé(s) sur la base d'au moins une partie des signaux de réponse reçus, dans lequel
- dans le premier mode, soit un premier vecteur de signal complexe est déterminé à partir du signal initial et le signal de réponse est constitué du premier vecteur de signal complexe ou du premier vecteur de signal complexe réciproque ou du premier vecteur de signal complexe de manière conjuguée, soit une première phase est déterminée à partir du signal initial reçu et le signal de réponse est constitué de la première phase ou de la première phase inversée, et
- dans le second mode, le signal de réponse est formé indépendamment du signal initial reçu, un vecteur de signal de réception est déterminé au moins par rapport à un signal initial reçu et est transmis par l'intermédiaire de l'interface de données, et au moins une fonction de transfert et/ou un des décalages temporels est (sont) déterminé(s) sur la base d'au moins une partie des signaux de réponse reçus et d'au moins une partie du vecteur de réception transmis.

**2.** Procédé selon la revendication 1, **caractérisé en ce que** les premières étapes des suites d'étapes sont exécutées pendant le cycle de mesure suivant un premier ordre et les secondes étapes des suites d'étapes sont exécutées de manière correspondante au premier ordre ou dans un ordre inverse par rapport au premier ordre.

**3.** Procédé selon la revendication 1 ou 2, **caractérisé en ce que**, à l'intérieur de chaque suite d'étapes, la seconde fréquence porteuse correspond à la première fréquence porteuse ou est différente de la première fréquence porteuse.

**4.** Procédé selon l'une quelconque des revendications précédentes, **caractérisé en ce que**, pendant un cycle de mesure, les secondes étapes de la totalité des suites d'étapes sont exécutées.

**5.** Procédé selon l'une quelconque des revendications précédentes, **caractérisé en ce qu'**au moins toujours un nœud radio fonctionne en tant qu'initiateur et au moins toujours un nœud radio fonctionne en tant que transpondeur, dans lequel chaque nœud radio fonctionne sur plusieurs suites d'étapes au moins une fois en tant qu'initiateur et au moins une fois en tant que transpondeur, ou chaque nœud radio fonctionne sur plusieurs suites d'étapes uniquement en tant qu'initiateur ou uniquement en tant que transpondeur.

6. Procédé selon l'une quelconque des revendications précédentes, **caractérisé en ce qu'**un écart entre ledit au moins un initiateur et ledit au moins un transpondeur est défini sur la base de la fonction de transfert et/ou du décalage temporel déterminé(s).

7. Procédé selon l'une quelconque des revendications précédentes, **caractérisé en ce que**, pour au moins une fonction de transfert déterminée, une analyse de trajets multiples est réalisée.

8. Procédé selon l'une quelconque des revendications précédentes, **caractérisé en ce qu'**un filtre est appliqué sur les signaux de réponse reçus et/ou sur les signaux initiaux reçus.

9. Procédé selon l'une quelconque des revendications précédentes, **caractérisé en ce que**, pour chaque répétition des suites d'étapes, une amplitude et/ou une phase du signal initial est (sont) modifiée(s) en plus de la fréquence porteuse du signal initial.

10. Procédé selon l'une quelconque des revendications précédentes, **caractérisé en ce que** l'initiateur émet le signal initial pendant une première période d'émission et le transpondeur émet le signal de réponse pendant une seconde période d'émission, dans lequel la première période d'émission et la seconde période d'émission comprennent respectivement plusieurs fenêtres temporelles successives, l'émission a lieu respectivement uniquement pendant les fenêtres temporelles et deux fenêtres temporelles successives se succèdent respectivement immédiatement dans le temps ou présentent dans le temps un écart l'une par rapport à l'autre.

Fig. 1

EP 3 639 549 B1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3243812 A
- DE 102009060505 B4
- DE 102009060593 A1
- DE 102009592 B4
- WO 0201247 A2
- DE 102009060591 A1
- WO 2005119379 A1